# EUROPEAN PATENT APPLICATION

(11) **EP 4 365 964 A1**
(43) Date of publication of application: **08.05.2024**
(21) Application number: 22882333.2
(22) Date of filing: 28.06.2022
(51) Int. Cl.: H01L 31/18, H01L 21/02, H01L 31/0216, C23C 16/34, C23C 16/40, C23C 16/513

(54) **N-TYPE DOUBLE-SIDED SOLAR CELL PREPARATION METHOD**

(30) Priority: 19.10.2021 CN 202111215056
(71) Applicant: Tongwei Solar (Meishan) Co., Ltd., Meishan, Sichuan 620041 (CN)
(72) Inventor: XU, Wenzhou, Meishan, Sichuan 620041 (CN); YAO, Qian, Meishan, Sichuan 620041 (CN); XING, Guoqiang, Meishan, Sichuan 620041 (CN)
(74) Representative: Marks & Clerk LLP
(86) International application number: PCT/CN2022/101847
(87) International publication number: WO 2023/065710

(57) **Abstract**

The present disclosure belongs to the technical field of N-type double-sided solar cells. Disclosed is an N-type double-sided solar cell preparation method. The preparation method comprises: sequentially forming a front aluminum oxide passivation layer and a front silicon nitride anti-reflection layer on a front face of an N-type silicon wafer. The front aluminum oxide passivation layer is prepared by using a plasma-enhanced atomic layer deposition method, and the deposition conditions thereof involve: any frequency in the frequency range of 40 kHz to 400 kHz is selected to be a radio-frequency power supply frequency, a gaseous aluminum source is first introduced into a plasma apparatus in a vacuum state, such that a layer of aluminum source molecules is adsorbed on the surface of the silicon wafer, and a gaseous oxygen source is then introduced, such that the oxygen source is ionized into plasma and reacts with the aluminum source to obtain aluminum oxide. An oxygen source is ionized into plasma in a plasma apparatus, and the plasma has relatively high energy and activity, and can be quickly combined with aluminum source molecules which are adsorbed on an N-type silicon wafer, so as to generate an aluminum oxide film, such that the open-circuit voltage and the conversion efficiency of an N-type double-sided solar cell are improved.

## Description

### CROSS-REFERENCE TO RELATED APPLICATIONS

This application claims priority to Chinese patent application No. 202111215056.5, titled "N-TYPE DOUBLE-SIDED SOLAR CELL PREPARATION METHOD", filed with the China National Intellectual Property Administration on October 19, 2021, the entire content of which is incorporated herein by reference.

### TECHNICAL FIELD

The present disclosure relates to the technical field of N-type double-sided solar cells, and in particular, to a method for preparing an N-type double-sided solar cell.

### BACKGROUND

In crystalline silicon solar cells, there is severe recombination in the metal-semiconductor contact area. The severe recombination of carriers has become an important factor restricting the efficiency development of the crystalline silicon solar cells. Setting a passivation layer in the crystalline silicon solar cells can enable the cell to have a higher efficiency limit, which is closest to a theoretical limit efficiency of the crystalline silicon solar cell. Since aluminum oxide is an insulating material with a wide energy band gap of about 9 eV and a large energy band difference, and the dielectric constant of aluminum oxide is more than twice higher than that of silicon oxide, aluminum oxide can be used to form a dielectric layer on a silicon substrate.

A boron-containing compound is diffused on a front side of an N-type double-sided cell to form a P-type doped layer. In the selection of front passivation materials for the N-type double-sided cell, since a fixed charge density of an aluminum oxide film is about 10×10¹² to 10×10¹³cm⁻², the P-type doped layer may be in an accumulation state and generate an electric field close to a surface of a silicon wafer. This electric field can repel carriers with the same polarity. The negative charges in the aluminum oxide film layer and the minority carriers (electrons) in the P-type silicon wafer repel each other, thereby preventing the aluminum oxide film from combining with a recombination center on the surface of the silicon wafer, reducing the surface recombination rate and achieving field passivation. Using field passivation and chemical passivation, the aluminum oxide passivation film achieves an excellent passivation effect on the front side of the N-type double-sided cell, and an open-circuit voltage of the cell is improved.

In the related art, the aluminum oxide film can be prepared by thermal atomic layer deposition (ALD). Specifically, in a vacuum state and at a temperature ranging from 200°C to 450°C, trimethylaluminum (Al(CH₃)₃) is firstly introduced to adsorb trimethylaluminum molecules on the surface of the silicon wafer, and nitrogen is purged to blow off excess atoms, leaving only a layer of trimethylaluminum molecules adsorbed on the surface of the silicon wafer. Then, water or ozone is introduced, and the oxygen atoms in the water or ozone combine with the trimethylaluminum molecules adsorbed on the silicon wafer to form an aluminum oxide film. The open-circuit voltage of the N-type double-sided solar cell prepared by the above method is not high and the conversion efficiency is relatively low.

### SUMMARY

In view of the shortcomings of related art, embodiments of the present disclosure provide a method for preparing an N-type double-sided solar cell, which can increase the open-circuit voltage and the conversion efficiency of the N-type double-sided solar cell.

Embodiments of the present disclosure provide a method for preparing an N-type double-sided solar cell. The method may include: forming a front side aluminum oxide passivation layer and a front side silicon nitride anti-reflection layer sequentially on a front side of an N-type silicon wafer. The front side aluminum oxide passivation layer is prepared using a plasma-enhanced atomic layer deposition method, and deposition conditions include: any frequency within a frequency range of 40 kHz to 400 kHz is selected as a radio-frequency power frequency. A gaseous aluminum source is firstly introduced into the plasma apparatus in a vacuum state, such that a layer of aluminum source molecules is adsorbed on a surface of the silicon wafer, and then a gaseous oxygen source is introduced, such that the oxygen source is ionized into a plasma and reacts with the aluminum source to obtain aluminum oxide.

In the related art, the plasma-enhanced atomic layer deposition (PEALD) method is a method for preparing a high-quality ultra-thin film at a low temperature. The film is generally prepared under the condition of a radio-frequency power frequency of 10 MHz to 10 GHz. The inventors found that if the front side aluminum oxide passivation layer is directly prepared using a plasma-enhanced atomic layer deposition process in the related art, the preparation effect of the aluminum oxide passivation layer is not ideal, and the obtained open-circuit voltage and conversion efficiency of the N-type double-sided solar cell are not high. Therefore, in the related art, a thermal atomic layer deposition method is generally used to prepare the front side aluminum oxide passivation layer, but the obtained open-circuit voltage and conversion efficiency of the N-type double-sided solar cell are still not high.

The inventors continued research and found that it was not the case that the plasma-enhanced atomic layer deposition method was not suitable for preparing the front side aluminum oxide passivation layer, but that the selection range of the radio-frequency power frequency in the related art was inappropriate. In the present disclosure, the radio-frequency power frequency is selected within the range of 40kHz to 400kHz, such that the oxygen source can be ionized into a plasma. Since the plasma has relatively high energy and activity, it can quickly be combined with the aluminum source molecules adsorbed on the N-type silicon wafer and generate an aluminum oxide film, thereby improving the open-circuit voltage and the conversion efficiency of the N-type double-sided solar cell.

In some embodiments of the present disclosure, the gaseous aluminum source is one of trimethylaluminum, triethylaluminum, dimethylaluminum chloride, and aluminum ethoxide, and the gaseous oxygen source is one of oxygen, nitrous oxide, ozone, and water vapor. The aluminum source has a low melting point, easily exists in a gaseous state, and is easily adsorbed on the surface of the N-type silicon wafer. The oxygen source can be ionized into a plasma under the condition of a low radio-frequency power frequency, so as to react with trimethylaluminum to obtain an aluminum oxide film.

In some embodiments of the present disclosure, a deposition temperature is within a range of 80°C to 400°C. Using the plasma-enhanced atomic layer deposition method, a dense and high-purity front side aluminum oxide passivation layer can be formed under the condition of a low radio-frequency power frequency and a low temperature, so as to improve the performance of the cell.

In some embodiments of the present disclosure, the radio-frequency power frequency is within a range of 40 kHz to 200 kHz, and the deposition temperature is within the range of 80°C to 200°C. The aluminum oxide film with good film forming effect can be obtained under the condition of a low radio-frequency power frequency and a low temperature.

In some embodiments of the present disclosure, any frequency within the frequency range of 40 kHz to 400 kHz is selected as the radio-frequency power frequency, and a temperature is within a range of 80°C to 400°C. In the vacuum state, trimethylaluminum is firstly introduced into the plasma apparatus, such that trimethylaluminum molecules are adsorbed on the surface of the silicon wafer, and a rare gas is introduced for purging, such that a layer of trimethylaluminum molecules is adsorbed on the surface of the silicon wafer, and then oxygen is introduced, such that the oxygen is ionized into the plasma and reacts with the trimethylaluminum to obtain the aluminum oxide. The single-layer aluminum oxide layer obtained by the above method has a lattice constant of 0.125 nm.

In some embodiments of the present disclosure, a thickness of the front side aluminum oxide passivation layer is within a range of 2 nm to 20 nm. Using the above method, the front side aluminum oxide passivation layer with a thickness of 2 nm to 20 nm can be accurately prepared after multiple cycles, and the thickness is easier to control.

In some embodiments of the present disclosure, the method for preparing the N-type double-sided solar cell may include: firstly, performing double-sided texturing on a surface of the N-type silicon wafer; performing single-sided diffusion on the front side of the N-type silicon wafer to form a front side P-type doped layer; forming the front side aluminum oxide passivation layer and the front side silicon nitride anti-reflection layer on the front side of the N-type silicon wafer; forming a tunneling silicon oxide layer and a back side intrinsic amorphous silicon layer sequentially on a back side of the N-type silicon wafer, and forming a back side N-type doped layer on the back side intrinsic amorphous silicon layer; and forming a back side silicon nitride anti-reflection layer on the back side of the N-type silicon wafer.

In some embodiments of the present disclosure, the performing double-sided texturing on the surface of the N-type silicon wafer may include: cleaning the N-type silicon wafer, and texturing the N-type silicon wafer to form a pyramid texturing surface using an alkali solution.

In some embodiments of the present disclosure, the step of performing single-sided diffusion on the front side of the N-type silicon wafer to form the front side P-type doped layer may include: performing single-sided boron diffusion on a front side of the textured N-type silicon wafer.

In some embodiments of the present disclosure, the front side silicon nitride anti-reflection layer may be formed on the front side of the N-type silicon wafer using a PECVD method, and/or the back side silicon nitride anti-reflective layer may be formed on the back side of the N-type silicon wafer using the PECVD method.

In some embodiments of the present disclosure, the method for preparing the N-type double-sided solar cell may further include: performing grid line printing on the front side and the back side of the silicon wafer by screen printing; and perform sintering to form a front electrode and a back electrode.

### BRIEF DESCRIPTION OF THE DRAWINGS

In order to describe the technical solutions in the embodiments of the present disclosure more clearly, the following briefly introduces the accompanying drawings required for describing the embodiments. It should be understood that, the accompanying drawings in the following description shows merely some embodiments of the present disclosure, and do not constitute a limitation to scope of the present disclosure. For a person of ordinary skill in the art, other drawings can also be obtained according to these accompanying drawings without making any creative efforts.
FIG. 1 is a schematic diagram illustrating a layer structure of an N-type double-sided solar cell according to an embodiment of the present disclosure.
FIG. 2 is a process flow chart illustrating a method for preparing an N-type double-sided solar cell according to an embodiment of the present disclosure.

Reference numerals:
110: front side silicon nitride anti-reflection layer; 120: front side aluminum oxide passivation layer; 130: front side P-type doped layer; 140: N-type silicon wafer; 150: back tunneling silicon oxide layer; 160: back side intrinsic amorphous silicon layer; 170: back side N-type doped layer; 180: back side silicon nitride anti-reflection layer.

### DETAILED DESCRIPTION OF THE EMBODIMENTS

In order to make the above objectives, technical solutions and advantages of the present disclosure more obvious and understandable, the technical solutions of the present disclosure will be described clearly and completely below.

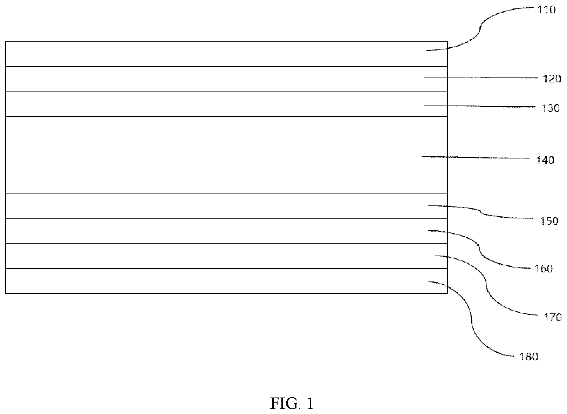

FIG. 1 is a schematic diagram illustrating a layer structure of an N-type double-sided solar cell according to an embodiment of the present disclosure. Referring to FIG. 1, the N-type double-sided solar cell includes, in order from top to bottom, a front side silicon nitride anti-reflection layer 110, a front side aluminum oxide passivation layer 120, a front side P-type doped layer 130, an N-type silicon wafer 140, a back tunneling silicon oxide layer 150, a back side intrinsic amorphous silicon layer 160, a back side N-type doped layer 170, and a back side silicon nitride anti-reflection layer 180.

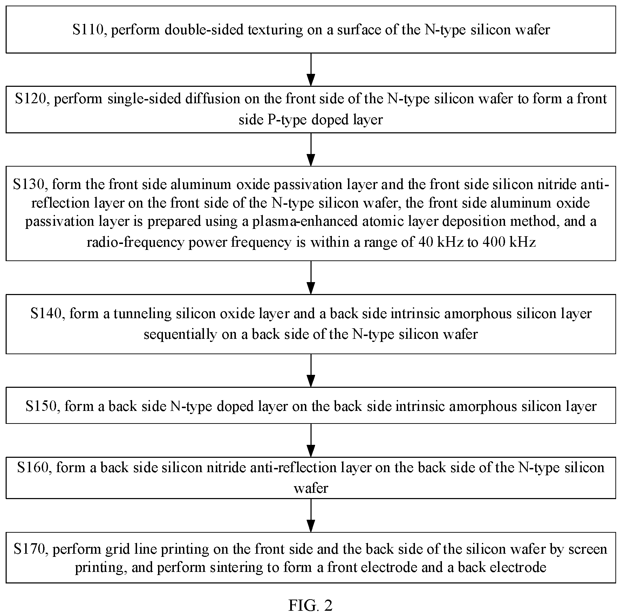

FIG. 2 is a process flow chart illustrating a method for preparing an N-type double-sided solar cell according to an embodiment of the present disclosure. Referring to FIG. 1 and FIG. 2, the method for preparing the N-type double-sided solar cell includes the following steps.

In step S 110, firstly, double-sided texturing is performed on a surface of the N-type silicon wafer 140. Optionally, the N-type silicon wafer 140 is cleaned and textured using an alkali solution (for example, strong alkali, NaOH or KOH), to form a pyramid texturing surface. The geometric size and specification shape of the silicon wafer are not limited.

In step S120, single-sided diffusion is performed on the front side of the N-type silicon wafer 140 to form the front side P-type doped layer 130. Optionally, single-sided boron diffusion is performed on the front side of the textured N-type silicon wafer 140.

For example, the liquid boron tribromide BBr₃ or gaseous boron chloride BCl₃ is used to diffuse for 150 min to 200 min at a temperature of 900 °C to 1050 °C. Then, the back side and edges of the N-type silicon wafer 140 are chemically etched using an HF solution with a mass concentration of 5% to 15% as an etching solution, so as to obtain the front side P-type doped layer 130.

In step S130, the front side aluminum oxide passivation layer 120 and the front side silicon nitride anti-reflection layer 110 are formed on the front side of the N-type silicon wafer 140. Optionally, the front side aluminum oxide passivation layer 120 is prepared using a plasma-enhanced atomic layer deposition (PEALD) method, and deposition conditions include: any frequency within a frequency range of 40 kHz to 400 kHz is selected as a radio-frequency power frequency. In a vacuum state, a gaseous aluminum source is firstly introduced into a plasma apparatus, such that a layer of aluminum source molecules is adsorbed on a surface of the silicon wafer, and then a gaseous oxygen source is introduced, such that the oxygen source is ionized into a plasma and reacts with the aluminum source to obtain the front side aluminum oxide passivation layer 120.

The oxygen source refers to a substance with oxidizing properties under the action of an electric field. Optionally, the gaseous aluminum source is one of trimethylaluminum, triethylaluminum, dimethylaluminum chloride, and aluminum ethoxide, and the gaseous oxygen source is one of oxygen, nitrous oxide, ozone and water vapor. The trimethylaluminum is an organic aluminum source, which can be easily adsorbed on the surface of the N-type silicon wafer 140. The oxygen and nitrous oxide can be ionized into the plasma under the condition of low radio-frequency power frequency, so as to react with the trimethylaluminum to obtain an aluminum oxide film.

In the present disclosure, a deposition temperature is within a range of 80°C to 400°C. Using the plasma-enhanced atomic layer deposition method, a dense and high-purity front side aluminum oxide passivation layer 120 can be formed under the condition of a low radio-frequency power frequency and a low temperature, so as to improve the performance of the cell.

Optionally, the radio-frequency power frequency is within a range of 40 kHz to 200 kHz, and the deposition temperature is within the range of 80°C to 200°C. The aluminum oxide film with good film forming effect can be obtained under the condition of a low radio-frequency power frequency and a low temperature.

Exemplarily, when the plasma-enhanced atomic layer deposition method is used to prepare the front side aluminum oxide passivation layer 120, the radio-frequency power frequency of the plasma apparatus is 40 kHz, 200 kHz or 400 kHz, and the deposition temperature of the plasma apparatus is 80°C, 100°C, 120°C, 150°C, 200°C, 300°C or 400°C.

For example, any frequency within the frequency range of 40 kHz to 400 kHz is selected as the radio-frequency power frequency, and the deposition temperature is within the range of 80°C to 400°C. In the vacuum state, the trimethylaluminum is firstly introduced into the plasma apparatus, such that trimethylaluminum molecules are adsorbed on the surface of the silicon wafer, and a rare gas is introduced for purging, such that a layer of trimethylaluminum molecules is adsorbed on the surface of the silicon wafer, and then oxygen is introduced, such that the oxygen is ionized into the plasma and reacts with the trimethylaluminum to obtain the aluminum oxide. The single-layer aluminum oxide layer obtained by the above method has a lattice constant of 0.125 nm. After multiple cycles, the front side aluminum oxide passivation layer 120 with a thickness of 2 nm to 20 nm can be accurately prepared, and the thickness is easier to control.

It should be noted that in this disclosure, the form and shape of the PEALD equipment is not limited, such as tubular or plate equipment, nor is it limited to the equipment manufacturer and the environmental conditions of use. The material and shape of the silicon wafer carrying device are not limited, such as the shape and size of the graphite boat.

Optionally, the front side silicon nitride anti-reflection layer 110 is formed on the front side of the N-type silicon wafer 140 using a PECVD (plasma enhance chemical vapor deposition) method.

In step S140, a tunneling silicon oxide layer and a back side intrinsic amorphous silicon layer 160 are sequentially formed on a back side of the N-type silicon wafer 140. Optionally, the N-type silicon wafer 140 after step S130 is placed in a chamber of a PECVD equipment, and ozone gas is introduced into the chamber of the PECVD equipment for oxidation treatment, so as to form a back tunneling silicon oxide layer 150 on the back side of the N-type silicon wafer 140. Then, a mixed gas of H₂ and SiH₄ is introduced to deposit the back side intrinsic amorphous silicon layer 160.

In step S150, a back side N-type doped layer 170 is formed on the back side intrinsic amorphous silicon layer 160. Optionally, phosphorus diffusion is performed on the back side of the N-type silicon wafer 140 after step S140.

For example, the liquid phosphorus oxychloride POCl₃ is used to diffuse for 30 min to 60 min at a temperature of 750°C to 850°C. Then, the edges of the N-type silicon wafer 140 are chemically etched using an HF solution with a mass concentration of 2% to 3% as an etching solution, to obtain the back side N-type doped layer 170. Since the concentration of the HF solution is relatively low, the front side silicon nitride anti-reflective layer 110 is basically undamaged.

In step S160, a back side silicon nitride anti-reflection layer 180 is formed on the back side of the N-type silicon wafer 140. Optionally, the back side silicon nitride anti-reflection layer 180 is formed on the back side of the N-type silicon wafer 140 using the PECVD method.

In step S170, grid line printing is performed on the front side and the back side of the silicon wafer by screen printing, and sintering is performed to form a front electrode and a back electrode.

In the related art, the plasma-enhanced atomic layer deposition (PEALD) method is a method for preparing a high-quality ultra-thin film at a low temperature. The film is generally prepared under the condition of a radio-frequency power frequency of 10 MHz to 10 GHz. The inventors found that if the front side aluminum oxide passivation layer 120 is directly prepared using a plasma-enhanced atomic layer deposition process in the related art, the preparation effect of the aluminum oxide passivation layer is not ideal, and the obtained open-circuit voltage and conversion efficiency of the N-type double-sided solar cell are not high. Therefore, in the related art, a thermal atomic layer deposition method is generally used to prepare the front side aluminum oxide passivation layer 120, but the obtained open-circuit voltage and conversion efficiency of the N-type double-sided solar cell are still not high.

The inventors continued research and found that it was not the case that the plasma-enhanced atomic layer deposition method was not suitable for preparing the front side aluminum oxide passivation layer 120, but that the selection range of the radio-frequency power frequency in the related art was inappropriate. In the present disclosure, the radio-frequency power frequency is selected within the range of 40kHz to 400kHz, and the temperature is not lower than 80°C, such that the oxygen or the nitrous oxide can be ionized into the plasma. Since the plasma has relatively high energy and activity, it can quickly be combined with the trimethylaluminum molecules adsorbed on the N-type silicon wafer 140 and generate an aluminum oxide film, thereby improving the open-circuit voltage and the conversion efficiency of the N-type double-sided solar cell.

The radio-frequency power frequency is selected within the range of 40kHz to 400kHz. Since the power supply is a medium-low frequency power supply, and the signal changes slowly and the waveform is smooth, the uniformity of the film layer can be better, and a single-component aluminum oxide film can be prepared, and the passivation performance of the aluminum oxide film is better. The temperature for preparing the front side aluminum oxide passivation layer 120 is within the range of 80°C to 400°C, the temperature range is wide, and the front side aluminum oxide passivation layer 120 can be grown at a low temperature, thereby reducing the energy consumption.

In order to make the objectives, technical solutions, and advantages of the embodiments of the present disclosure clearer, the technical solutions in the embodiments of the present disclosure will be clearly and completely described below. If the specific conditions are not specified in the embodiments, the conditions should be carried out according to the conventional conditions or the conditions recommended by the manufacturer. If the manufacturer of the reagents or equipment used is not indicated, they are all conventional products that can be purchased commercially.

### EXAMPLES

The present embodiment provides a method for preparing an N-type double-sided solar cell, including the following steps.
(1) The N-type silicon wafer is cleaned, and textured using a NaOH solution, to form a pyramid texturing surface.
(2) The gaseous boron chloride BCl₃ is used to diffuse for 200 min at a temperature of about 950°C. Then, the back side and edges of the N-type silicon wafer are chemically etched using an HF solution with a mass concentration of 10% as an etching solution, to obtain the front side P-type doped layer.
(3) In a vacuum state, the trimethylaluminum is firstly introduced into the plasma apparatus, such that trimethylaluminum molecules are adsorbed on the surface of the silicon wafer, and a rare gas is introduced for purging, such that a layer of trimethylaluminum molecules is adsorbed on the surface of the silicon wafer. Then, oxygen is introduced, and the radio-frequency power frequency is controlled within the range of 40 kHz to 400 kHz, and the deposition temperature is controlled within the range of 80°C to 400°C, such that the oxygen reacts with the trimethylaluminum to obtain the front side aluminum oxide passivation layer.

A front side silicon nitride anti-reflection layer is formed on the front side of the N-type silicon wafer using a PECVD method.
(4) The N-type silicon wafer after step (3) is placed in a chamber of a PECVD equipment, and ozone gas is introduced into the chamber of the PECVD equipment for oxidation treatment, to form a back tunneling silicon oxide layer on the back side of the N-type silicon wafer. Then, a mixed gas of H₂ and SiH₄ is introduced to deposit a back side intrinsic amorphous silicon layer.
(5) The liquid phosphorus oxychloride POCl₃ is used to diffuse for 40 min at a temperature of 800°C. Then, the edges of the N-type silicon wafer are chemically etched using an HF solution with a mass concentration of 2% as an etching solution, to obtain a back side N-type doped layer.
(6) A back side silicon nitride anti-reflection layer is formed on the back side of the N-type silicon wafer using the PECVD method.
(7) Grid line printing is performed on the front side and the back side of the silicon wafer by screen printing, and sintering is performed to form a front electrode and a back electrode.

The specific preparation conditions of the front side aluminum oxide passivation layer and the performance of the N-type double-sided solar cell are shown in Table 1.

**Table 1 preparation conditions of the front side aluminum oxide passivation layer and the performance of the N-type double-sided solar cell**

| | Deposition Method | Radio-frequency Power Frequency | Deposition Temperature (°C) | Sinton Test | I-V Test | |
|---|---|---|---|---|---|---|
| | | | | iVoc (mV) | Eta | Voc (mV) |
| Comparative Example 1 | Thermal ALD | 0 | 300 | 718.6 | 24.12% | 703.5 |
| Example 1 | PEALD | 40 kHz | 80 | 730.2 | 24.54% | 715.6 |
| Example 2 | PEALD | 40 kHz | 150 | 730.6 | 24.53% | 715.4 |
| Example 3 | PEALD | 40 kHz | 200 | 731.6 | 24.53% | 715.5 |
| Example 4 | PEALD | 40 kHz | 400 | 729.7 | 24.51% | 714.2 |
| Example 5 | PEALD | 200 kHz | 80 | 731.0 | 24.54% | 715.9 |
| Example 6 | PEALD | 200 kHz | 150 | 730.8 | 24.54 | 714.7 |
| Example 7 | PEALD | 200 kHz | 200 | 730.4 | 24.53% | 715.2 |
| Example 8 | PEALD | 200 kHz | 400 | 729.6 | 24.52% | 714.6 |
| Example 9 | PEALD | 400 kHz | 80 | 731.5 | 24.55% | 716.8 |
| Example 10 | PEALD | 400 kHz | 150 | 730.8 | 24.54 | 715.5 |
| Example 11 | PEALD | 400 kHz | 200 | 729.4 | 24.53% | 714.4 |
| Example 12 | PEALD | 400 kHz | 400 | 730.8 | 24.52% | 715.1 |

As can be seen from Table 1, compared with Examples 1 to 12, since the front side aluminum oxide passivation layer in Comparative Example 1 is prepared using the thermal atomic layer deposition method, the open-circuit voltage and the conversion efficiency of the obtained N-type double-sided solar cell is relatively low.

It can be seen from Examples 1 to 12 that in the present disclosure, when the radio-frequency power frequency is within the range of 40 kHz to 200 kHz, and the deposition temperature is within the range of 80°C to 200°C, the obtained open-circuit voltage and the conversion efficiency of the cell are higher, thus indicating that the passivation performance of the aluminum oxide passivation layer is better.

The above-described embodiments are some, but not all, of the embodiments of the present disclosure. The detailed description of the embodiments of the disclosure is not intended to limit the claimed scope of the disclosure, but rather to represent selected embodiments of the disclosure. Based on the embodiments in this disclosure, all other embodiments obtained by those of ordinary skill in the art without creative efforts fall within the scope of protection of this disclosure.

### INDUSTRIAL APPLICABILITY

The present disclosure provides a method for preparing an N-type double-sided solar cell, which belongs to the technical field of N-type double-sided solar cells. The preparation method includes forming a front side aluminum oxide passivation layer and a front side silicon nitride anti-reflection layer sequentially on a front side of an N-type silicon wafer. The front side aluminum oxide passivation layer is prepared using a plasma-enhanced atomic layer deposition method. Deposition conditions include: any frequency within a frequency range of 40 kHz to 400 kHz is selected as a radio-frequency power frequency. In a vacuum state, a gaseous aluminum source is firstly introduced into a plasma apparatus, such that a layer of aluminum source molecules is adsorbed on a surface of the silicon wafer, and then a gaseous oxygen source is introduced, such that the oxygen source is ionized into a plasma and reacts with the aluminum source to obtain aluminum oxide. The oxygen source is ionized into the plasma in the plasma apparatus, since the plasma has relatively high energy and activity, it can quickly combine with the aluminum source molecules adsorbed on the N-type silicon wafer and generate an aluminum oxide film, thereby improving the open-circuit voltage and the conversion efficiency of the N-type double-sided solar cell.

In addition, it can be understood that the method for preparing the N-type double-sided solar cell of the present disclosure is reproducible, and can be used in a variety of industrial applications. For example, the method for preparing the N-type double-sided solar cell disclosed in the present disclosure can be used in the technical field of N-type double-sided solar cells.

## Claims

1. A method for preparing an N-type double-sided solar cell, comprising: forming a front side aluminum oxide passivation layer and a front side silicon nitride anti-reflection layer sequentially on a front side of an N-type silicon wafer, **characterized in that**,
the front side aluminum oxide passivation layer is prepared using a plasma-enhanced atomic layer deposition method, and deposition conditions comprise: any frequency within a frequency range of 40 kHz to 400 kHz is selected as a radio-frequency power frequency, a gaseous aluminum source is firstly introduced into the plasma apparatus in a vacuum state, such that a layer of aluminum source molecules is adsorbed on a surface of the silicon wafer, and then a gaseous oxygen source is introduced, such that the oxygen source is ionized into a plasma and reacts with the aluminum source to obtain aluminum oxide.

2. The method for preparing the N-type double-sided solar cell of claim 1, **characterized in that** the gaseous aluminum source is one of trimethylaluminum, triethylaluminum, dimethylaluminum chloride, and aluminum ethoxide, and the gaseous oxygen source is one of oxygen, nitrous oxide, ozone, and water vapor.

3. The method for preparing the N-type double-sided solar cell of claim 1 or 2, **characterized in that** a deposition temperature is within a range of 80°C to 400°C.

4. The method for preparing the N-type double-sided solar cell of claim 3, **characterized in that** the radio-frequency power frequency is within a range of 40 kHz to 200 kHz, and the deposition temperature is within the range of 80°C to 200°C.

5. The method for preparing the N-type double-sided solar cell of any one of claims 1 to 4, **characterized in that** any frequency within the frequency range of 40 kHz to 400 kHz is selected as the radio-frequency power frequency, and a temperature is within a range of 80°C to 400°C, trimethylaluminum is firstly introduced into the plasma apparatus in the vacuum state, such that trimethylaluminum molecules are adsorbed on the surface of the silicon wafer, and a rare gas is introduced for purging, such that a layer of trimethylaluminum molecules is adsorbed on the surface of the silicon wafer, and then oxygen is introduced, such that the oxygen is ionized into the plasma and reacts with the trimethylaluminum to obtain the aluminum oxide.

6. The method for preparing the N-type double-sided solar cell of claim 5, **characterized in that** a thickness of the front side aluminum oxide passivation layer is within a range of 2 nm to 20 nm.

7. The method for preparing the N-type double-sided solar cell of claim 5 or claim 6, **characterized in that** the method comprises:
firstly, performing double-sided texturing on a surface of the N-type silicon wafer;
performing single-sided diffusion on the front side of the N-type silicon wafer to form a front side P-type doped layer;
forming the front side aluminum oxide passivation layer and the front side silicon nitride anti-reflection layer on the front side of the N-type silicon wafer;
forming a tunneling silicon oxide layer and a back side intrinsic amorphous silicon layer sequentially on a back side of the N-type silicon wafer, and forming a back side N-type doped layer on the back side intrinsic amorphous silicon layer; and
forming a back side silicon nitride anti-reflection layer on the back side of the N-type silicon wafer.

8. The method for preparing the N-type double-sided solar cell of claim 7, **characterized in that** the performing double-sided texturing on the surface of the N-type silicon wafer comprises:
cleaning the N-type silicon wafer, and texturing the N-type silicon wafer to form a pyramid texturing surface using an alkali solution.

9. The method for preparing the N-type double-sided solar cell of claim 7 or claim 8, **characterized in that** the step of performing single-sided diffusion on the front side of the N-type silicon wafer to form the front side P-type doped layer comprises:
performing single-sided boron diffusion on a front side of the textured N-type silicon wafer.

10. The method for preparing the N-type double-sided solar cell of any one of claim 7 to claim 9, **characterized in that** the front side silicon nitride anti-reflection layer is formed on the front side of the N-type silicon wafer using a PECVD method, and/or the back side silicon nitride anti-reflective layer is formed on the back side of the N-type silicon wafer using the PECVD method.

11. The method for preparing the N-type double-sided solar cell of any one of claim 7 to claim 10, **characterized by** further comprising:
performing grid line printing on the front side and the back side of the silicon wafer by screen printing; and
perform sintering to form a front electrode and a back electrode.
